(19) **Europäisches Patentamt**
**European Patent Office**
**Office européen des brevets**

(11) **EP 1 754 977 B1**

(12) **EUROPEAN PATENT SPECIFICATION**

(45) Date of publication and mention of the grant of the patent:
**04.11.2015 Bulletin 2015/45**

(51) Int Cl.:
***G01R 31/36*** *(2006.01)*

(21) Application number: **06023772.4**

(22) Date of filing: **06.04.2005**

(54) **Battery state of charge estimator**

Schätzer für den Batterieladungszustand

Estimateur d'état de charge d'une batterie

(84) Designated Contracting States:
**DE FR GB IT**

(30) Priority: **06.04.2004 US 559921 P**
**16.03.2005 US 81978**
**16.03.2005 US 81979**
**16.03.2005 US 81980**

(43) Date of publication of application:
**21.02.2007 Bulletin 2007/08**

(62) Document number(s) of the earlier application(s) in accordance with Art. 76 EPC:
**05735309.6 / 1 733 244**

(73) Proprietor: **Cobasys, LLC**
**Orion MI 48359 (US)**

(72) Inventor: **Melichar, Robert**
**Troy**
**Michigan 48084 (US)**

(74) Representative: **Manitz, Finsterwald & Partner GbR**
**Postfach 31 02 20**
**80102 München (DE)**

(56) References cited:
**EP-A- 1 085 592    US-A- 5 412 323**

**Description**

CROSS-REFERENCE TO RELATED APPLICATIONS

This application claims the benefit of U.S. Provisional Application No. 60/559,921, filed on April 6, 2004, U.S. Patent Application Serial No. 11/081,979 filed on March 16, 2005, U.S. Patent Application Serial No. 11/081,980 filed on March 16, 2005 and Serial No. 11/081,978 filed on March 16, 2005.

FIELD OF THE INVENTION

The present invention relates to battery systems, and more particularly to state of charge tracking systems for battery systems.

BACKGROUND OF THE INVENTION

Battery systems may be used to provide power in a wide variety applications. Exemplary transportation applications include hybrid electric vehicles (HEV), electric vehicles (EV), Heavy Duty Vehicles (HDV) and Vehicles with 42-volt electrical systems. Exemplary stationary applications include backup power for telecommunications systems, uninterruptible power supplies (UPS), and distributed power generation applications.

Examples of the types of batteries that are used include nickel metal hydride (NiMH) batteries, lead-acid batteries and other types of batteries. A battery system may include a plurality of battery subpacks that are connected in series and/or in parallel. The battery subpacks may include a plurality of batteries that are connected in parallel and/or in series.

The maximum and/or minimum power that can be delivered by batteries, battery subpacks and/or battery systems varies over time as a function of a temperature of the batteries, battery state of charge (SOC) and/or battery age. Therefore, accurate estimation of battery SOC is important to the determination of maximum and minimum power.

The energy that can be provided by or sourced to a battery is a function of state of charge. When the battery state of charge is known and targeted during operation, an optimal ratio can maintained between the ability to accept amp-hours in charge and to provide amp-hours in discharge. As this optimal ratio can be maintained, there is a reduced need to oversize the battery system to assure adequate power assist and regeneration energy.

The document EP 1 085 592 describes a method for detecting abnormal battery cell.

For example in transportation applications such as HEVs or EVs, it is important for the powertrain control system to know the maximum and/or minimum power limit of the battery system. The powertrain control system typically receives an input request for power from an accelerator pedal. The powertrain control system interprets the request for power relative to the maximum power limit of the battery system (when the battery system is powering the wheels). The minimum power limits may be relevant during recharging and/or regenerative braking. Exceeding the maximum and/or minimum power limits may damage the batteries and/or the battery system and/or reduce the operational life of the batteries and/or the battery system. Being able to estimate the battery SOC accurately has been somewhat problematic - particularly when the battery system includes NiMH batteries.

SUMMARY OF THE INVENTION

The invention solves the problems by a battery control module according to claim 1, by the battery control module according to claim 9, by the method according to claim 17, and by the method according to claim 25.

A battery control module for a battery system comprises a voltage measuring module that measures battery voltage and a current measuring module that measures battery current. A state of charge (SOC) module communicates with the current and voltage measuring modules and estimates SOC based on relaxation voltage..

In other features, the SOC module enables the SOC estimation when a qualified charge swing follows a discharge swing and relaxation. The SOC module enables the SOC estimation when a qualified discharge swing follows a charge swing and relaxation. The SOC module accumulates charge swing during charging and identifies the qualified charge swing when the accumulated charge swing is within a charge swing window. The SOC module accumulates discharge swing during discharging and identifies the qualified discharge swing when the accumulated discharge swing is within a discharge swing window.

In still other features, the SOC module monitors rest periods during which the battery is neither charging nor discharging. The SOC module enables the SOC estimation when the rest period is greater than a threshold. The SOC module enables SOC estimation during charging when a first period between the qualified charge swing and the prior discharge swing and relaxation is less than a predetermined allowed time. The SOC module enables SOC estimation during charging when a second period between the qualified discharge swing and the prior charge swing and relaxation is less than a predetermined allowed time.

A battery control module for a battery system comprises a voltage measuring module that measures battery voltage and a current measuring module that measures battery current. A state of charge (SOC) module communicates with said current and voltage measuring modules and estimates SOC based on a power limit ratio.

In other features, the SOC module accumulates charge swing during charging, identifies maximum current during the charge swing and stores the maximum charge current, a charge swing and a charge power limit. The SOC module accumulates discharge swing during discharging, identifies maximum current during the discharge swing and stores the maximum discharge current, a discharge swing and a discharge power limit. The SOC module determines whether the charge swing is greater than a negative of a retained discharge swing.

In other features, the SOC module determines whether the maximum current is approximately equal to a negative of a retained discharge current. The SOC module includes a lookup table. The SOC module looks up the SOC as a function of the power limit ratio when the charge swing is greater than the retained discharge swing and the maximum current is approximately equal to the negative of the retained discharge current. The SOC module determines whether the discharge swing is greater than a negative of a retained charge swing.

in yet other features, the SOC module determines whether the maximum current is approximately equal to a negative of a retained charge current The SOC module includes a lookup table. The SOC module looks up the SOC as a function of the power limit ratio when the discharge swing is greater than the retained charge swing and the maximum current is approximately equal to the negative of the retained charge current.

A battery control module for a battery system comprises a voltage measuring module that measures battery voltage and a current measuring module that measures battery current. A state of charge (SOC) module communicates with the current and voltage measuring modules and estimates SOC when an accumulated charge swing during charge is greater than or equal to an accumulated discharge swing during a prior discharge and a negative of a charge current is within a predetermined window of a negative of a retained discharge current during the prior discharge.

In other features, the SOC module estimates SOC when an accumulated discharge swing during discharge is greater than or equal to an accumulated charge swing during a prior charge and a negative of a discharge current is within a predetermined window of a negative of a retained charge current during the prior charge.

A battery control module for a battery system comprises a voltage measuring module that measures battery voltage and a current measuring module that measures battery current A state of charge (SOC) module communicates with the current and voltage measuring modules and estimates SOC when an accumulated discharge swing during discharge is greater than or equal to an accumulated charge swing during a prior charge and a negative of a discharge current is within a predetermined window of a negative of a retained charge current during the prior charge.

Further areas of applicability of the present invention will become apparent from the detailed description provided hereinafter. It should be understood that the detailed description and specific examples, while indicating the preferred embodiment of the invention, are intended for purposes of illustration only and are not intended to limit the scope of the invention.

BRIEF DESCRIPTION OF THE DRAWINGS

The present invention will become more fully understood from the detailed description and the accompanying drawings, wherein:
FIG. 1 is a functional block diagram of a battery system including battery subpacks, battery control modules and a master control module;
FIG. 2 is a more detailed functional block diagram of a battery control module;
FIG. 3 is an equivalent circuit of a battery;
F1G. 4 is a graph of battery current as a function of time;
FiGs. 5A and 5B are flowcharts illustrating steps of a relaxation voltage approach for estimating state of charge;
FIG. 6 is a graph of battery current as a function of time with charge and discharge swing and charge and discharge events shown; and
FIG. 7 is a flowchart illustrating a power ratio approach of estimating battery state of charge.

DETAILED DESCRIPTION OF THE PREFERRED EMBODIMENTS

The following description of the preferred embodiment(s) is merely exemplary in nature and is in no way intended to limit the invention, its application, or uses. For purposes of clarity, the same reference numbers will be used in the drawings to identify the same elements. As used herein, the term module or device refers to an application specific integrated circuit (ASIC), an electronic circuit, a processor (shared, dedicated, or group) and memory that execute one or more software or firmware programs, a combinational logic circuit, and/or other suitable components that provide the described functionality. As used herein, the term current swing refers to current integrated over a duration during which the charge (polarity) is in one direction. Charge swing may be expressed in units of Amp-seconds or A-s.

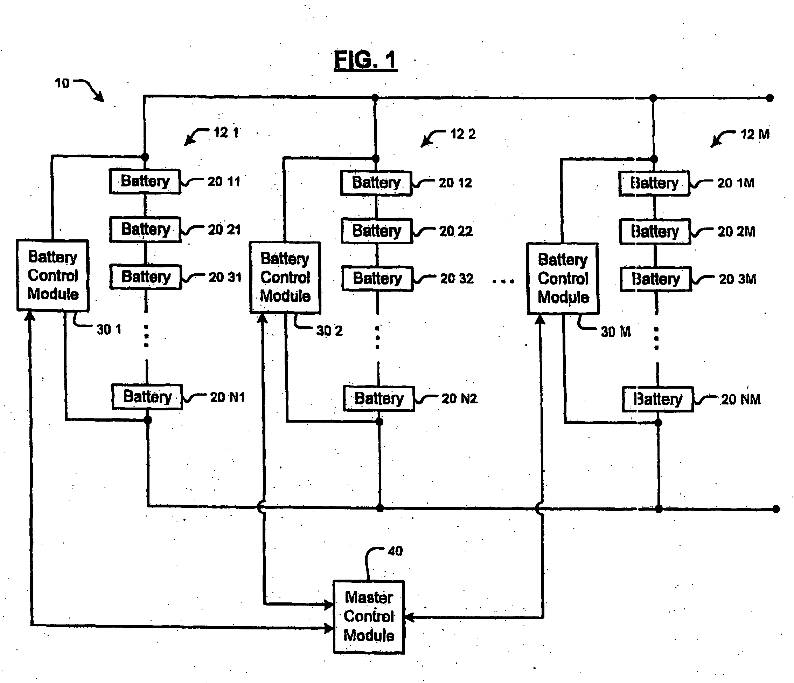

An exemplary system that can be used to calculate the SOC will be shown, although skilled artisans will appreciate that other systems may be used. Referring now to FIG. 1, an exemplary embodiment of a battery system 10 is shown to include M battery subpacks 12-1, 12-2, ..., and 12-M (collectively battery subpacks 12). The battery subpacks 12-1, 12-2, ..., and 12-M include N series connected batteries 20-11, 20-12, ..., and 20-NM (collectively batteries 20). Battery control modules 30-1, 30-2, ... and 30-M (collectively battery control modules 30) are associated with each of the battery subpacks 12-1, 12-2, ... and 12-M, respectively. In some embodiments, M is equal to 2 or 3, although additional or fewer subpacks may be used. In some embodiments, N is equal to 12-24, although additional and/or fewer batteries may be used.

The battery control modules 30 sense voltage across and current provided by the battery subpacks 12. Alternatively, the battery control modules 30 may monitor one or more individual batteries 20 in the battery subpacks 12 and appropriate scaling and/or adjustment is performed. The battery control modules 30 communicate with a master control module 40 using wireless and/or wired connections. The master control module 40 receives the power limits from the battery control modules 30 and generates a collective power limit. The SOC can be calculated for each module, in groups and/or collectively. The battery control module 30 may be integrated with the master control module 40 in some embodiments.

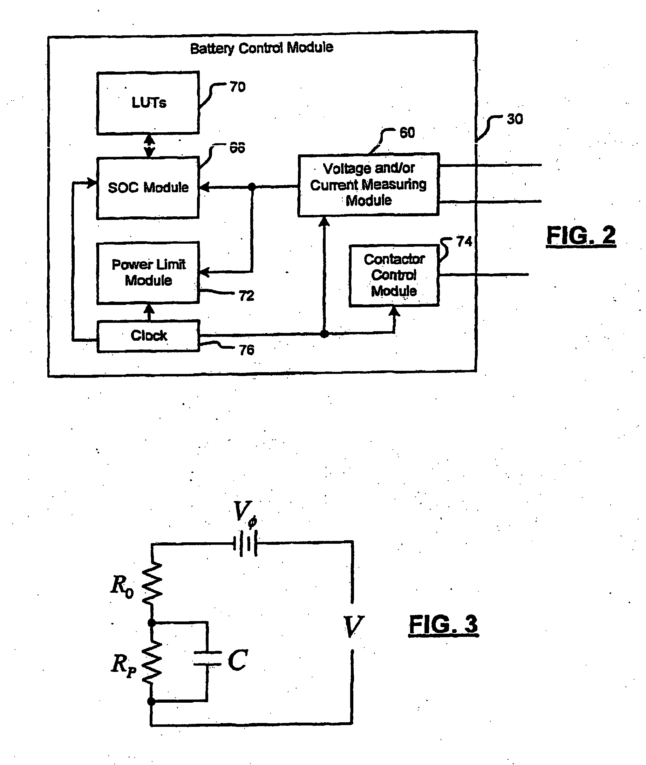

Referring now to FIG. 2, some of the elements of the battery control modules 30 are shown. The battery control modules 30 include a voltage and/or current measuring module 60 that measures voltage across the battery subpack 12 and/or across one or more individual batteries 20 in the battery subpack 12. The battery control modules 30 further include a battery state of charge (SOC) module 68 that periodically calculates the SOC of the batteries 20 in the battery subpacks 12. In one implementation, the SOC module 68 uses a power ratio estimation and/or $V_0$ approach, as will be described below. In another implementation, the SOC module 68 uses a relaxation voltage SOC estimation approach, as will be described below. The SOC module 68 may employ a lookup table 70, formulas and/or other methods.

A power limit module 72 calculates a maximum current limit $I_{lim}$, voltage limit $V_{lim}$, and/or power limit $P_{lim}$ for the battery subpack 12 and/or one or more batteries 20 in the battery subpack 12, as will be described further below. The limits may be maximum and/or minimum limits. A contactor control module 74 controls one or more contactors (not shown) that are associated with the control and/or connection of the batteries 20 in the battery subpacks 12. A clock circuit 76 generates one or more clock signals for one or more modules within the battery control module 30.

Referring now to FIG. 3, an equivalent circuit for the battery 20 is shown where $R_0$ represents ohmic resistance of the battery, $V_P$ represents the polarization voltage, $V_0$ represents the open circuit or relaxation voltage, $I$ represents battery current and V represents battery voltage. V and $I$ are measured values. Rp varies with temperature, duration of applied current and SOC. $V_0$ and $R_0$ vary primarily with SOC. $V_P$ is equal to measured current $I$ times $R_p$. Using the equivalent circuit and Kirchoff's voltage rules for the battery 20, $V = V_0 + V_P + IR_0$.

Relaxation voltage is relatively insensitive to temperature and current demand and is a good indicator of SOC. A set of specialized current pulses can be used to condition the battery to yield SOC dependent relaxation voltages. This approach is referred to herein as relaxation voltage SOC estimation.

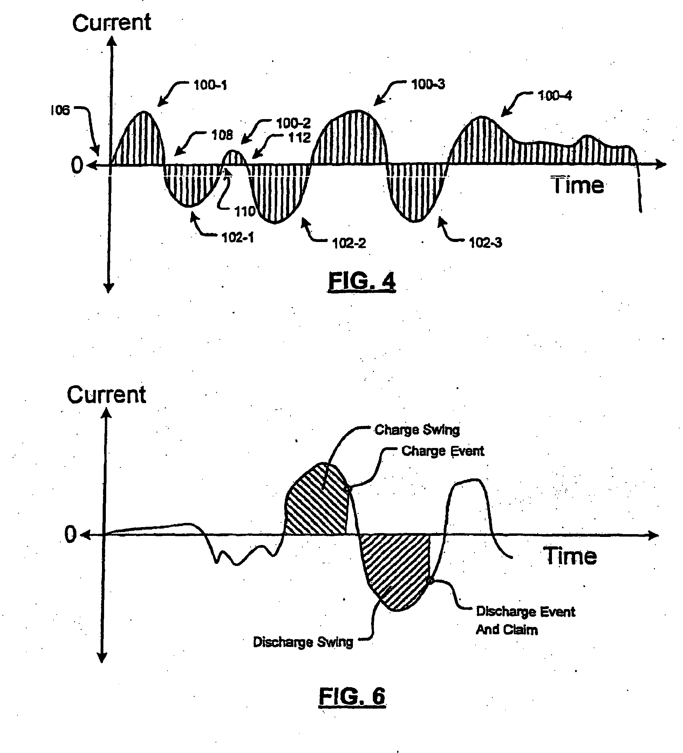

Referring now to FIG. 4, battery current is shown as a function of time. Current that is greater than zero, for example at 100-1, 100-2, 100-3, and 100-4, is charging current Current that is less than zero, for example at 102-1, 102-2, and 102-3, is discharging current The areas under the curve between points 106 and 108 and points 110 and 112 are defined as a charge swing in A-s. The area under the current curve between points 108 and 110 is defined as a discharge swing in A-s.

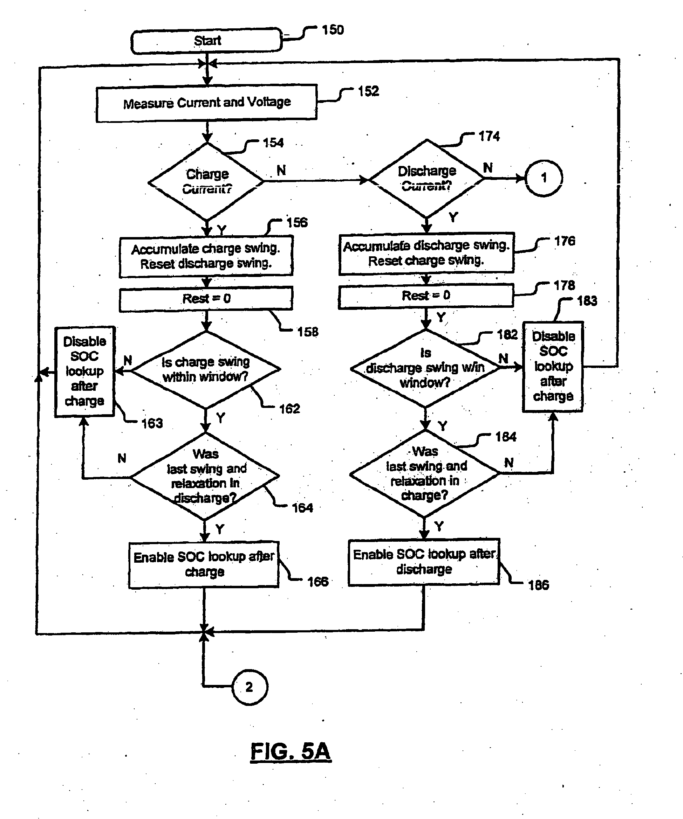

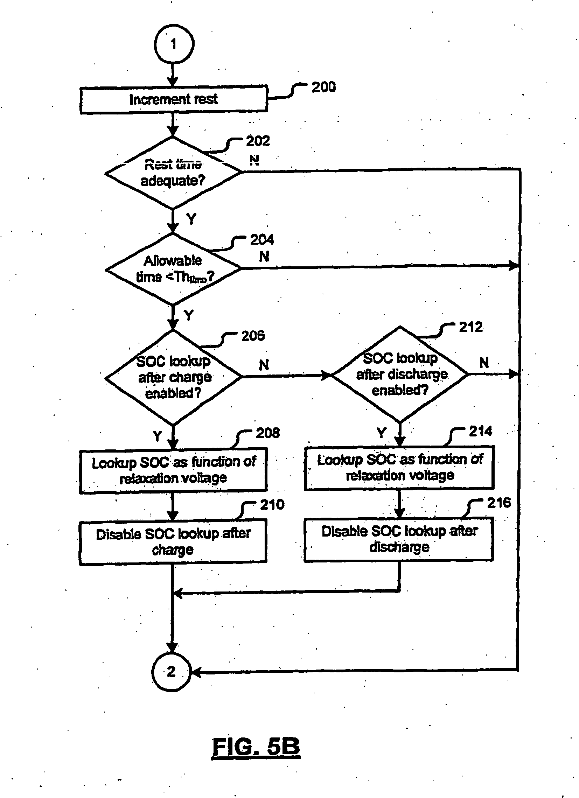

Referring now to FiGs. 5A and 5B, steps of a method for implementing a relaxation voltage SOC estimation approach are shown. The relaxation voltage estimation approach monitors battery current for a pair of power pulses, checks relaxation voltage after each and determines SOC using the lookup table 70. The relaxation voltage approach was derived based on the observation of voltage responses to pulses throughout a range operating of temperatures, such as -15°C to 45°C. The relaxation voltages were affected by swing amplitudes, pulse amplitudes and whether the battery was brought from top of charge or bottom of charge.

In FiGs. 5A and 5B, control begins with step 150. In step 152, the current and voltage are measured. In step 154, control determines whether the measured current is charge current (current > zero or a predetermined threshold). If step 154 is true, control accumulates charge swing and resets discharge swing in step 156. In step 158, control sets a rest variable equal to zero. In step 162, control determines whether the accumulated charge swing is within a predetermined window. The window may include upper and lower thresholds. In some implementations, the upper and lower thresholds are between 10% and 100% of battery capacity, although other values may be used. If not, control disables SOC lookup after charge in step 163 and returns to step 152.

If step 162 is true, control continues with step 164 and determines whether last swing and relaxation occurred in discharge. As used herein, relaxation refers to battery voltage asymptotically approaching the relaxation voltage. If not, control continues with step 163. If step 164 is true, control enables SOC lookup after charge in step 166.

If step 154 is false, control continues with step 174. In step 174, control determines whether the measured current is discharge current (current < zero or a predetermined threshold). If step 174 is true, control accumulates discharge swing and resets charge swing in step 176. In step 178, control sets the rest variable equal to zero. In step 182, control determines whether the accumulated discharge swing is within a predetermined window. The window may include upper and lower thresholds that may be similar to the accumulated charge swing thresholds or different therefrom. If not, control disables SOC lookup after discharge in step 183 and returns to step 152.

If step 182 is true, control continues with step 184 and determines whether last swing and relaxation occurred in charge. If not, control continues with step 183. If step 184 is true, control enables SOC lookup after discharge in step 186.

If step 174 is false, control continues in FIG. 5B with step 200 and increments the rest variable. In step 202, control determines whether rest time is adequate by comparing rest time to a threshold. In some implementations, approximately 120 seconds is used as a threshold, although other values may be used. If step 202 is true, control determines whether allowable time is less than a threshold time $Th_{time}$ in step 204. In some implementations, allowable time is equal to 240 seconds, although other values may be used. Exceeding this value tends to indicate that the pulses were not controlled enough for an SOC estimation.

If step 204 is true, control continues with step 206 and determines whether SOC lookup after charge is enabled. If step 206 is true, control looks up SOC as a function of relaxation voltage in step 208 and disables SOC lookup after charge in step 210 and control returns to step 152. If step 206 is false, control continues with step 212 and determines whether SOC lookup after discharge is enabled. If step 212 is true, control looks up SOC as a function of relaxation voltage in step 214 and disables SOC lookup after discharge in step 216 and control returns to step 152. If steps 202, 204 or 212 are false, control returns to step 152.

The power ratio SOC estimation approach monitors power pulse pairs. The method calculates the ratio of power capabilities in charge and discharge when the swings of the pulse pairs are approximately equal. The SOC is a function of the power ratio and is determined by a lookup table. The algorithm was derived while attempting to use inputs of current and voltage to solve for relaxation voltage $V_0$.

The voltage equation as the maximum or minimum power is held to a voltage limit is $V_{lim} = V_0 + V_P + I_{lim} R_0$. Substitution of the calculation for $V_0 + V_P$ from a prior sampling interval into the equation for $V_{lim}$ yields $V_{lim} = (V - IR_0) + I_{lim} R_0$. In this case, we are assuming that $V_0 + V_P$ for the current sampling interval is approximately equal to $V_0 + V_P$ of the prior sampling interval (in other words, $V_0 + V_P \cong V_{t=i-1} - I_{t=i-1} R_0$). This approximation is valid if the sampling interval is sufficiently small since the battery and ambient conditions are very similar. For example in some implementations, a sampling interval 10ms<T<500ms may be used, although other sampling intervals may be used. In one embodiment, T=100ms. Sampling intervals of 1 second have been used successfully. If the sampling interval is determined to be excessive in duration then $R_o$ would be increased as a constant or as a temperature dependent variable.

Solving for $I_{lim}$ yields the following:

$$I_{lim} = \frac{V_{lim} - V_{t=i-1} + I_{t=i-1} R_0}{R_0}.$$

Therefore, since $P_{lim} = V_{lim} I_{lim}$,

$$P_{lim} = V_{lim} \left( \frac{V_{lim} - V_{t=i-1} + I_{t=i-1} R_0}{R_0} \right).$$

At the time that power limit is established for a charge or discharge swing and measured current, the measured current and voltage values are stored. When the current is reversed, the swing amplitude passes the negative of the retained swing, and the current is approximately equal to the magnitude of the retained current, a power limit calculation is performed.

The power ratio is calculated by taking $P_{lim}$ in charge divided by $-P_{lim}$ in discharge for adjacent cycles. Even though $V_0$ and $V_P$ are no longer in the equation, their contributions are reflected in current and voltage measurements, which are functions of both the polarization build up and $V_0$. The polarization voltage $V_P$ during a charge swing is approximately equal to the polarization voltage $V_P$ during a discharge swing of approximately equal magnitude. Using this approximation, the power ratio SOC estimation is used to remove $V_P$ from the calculation. The use of the power limit ratio has the effect of adding consideration of the low discharge power at low SOC and the low charge acceptance at high SOC to the stated charge determination.

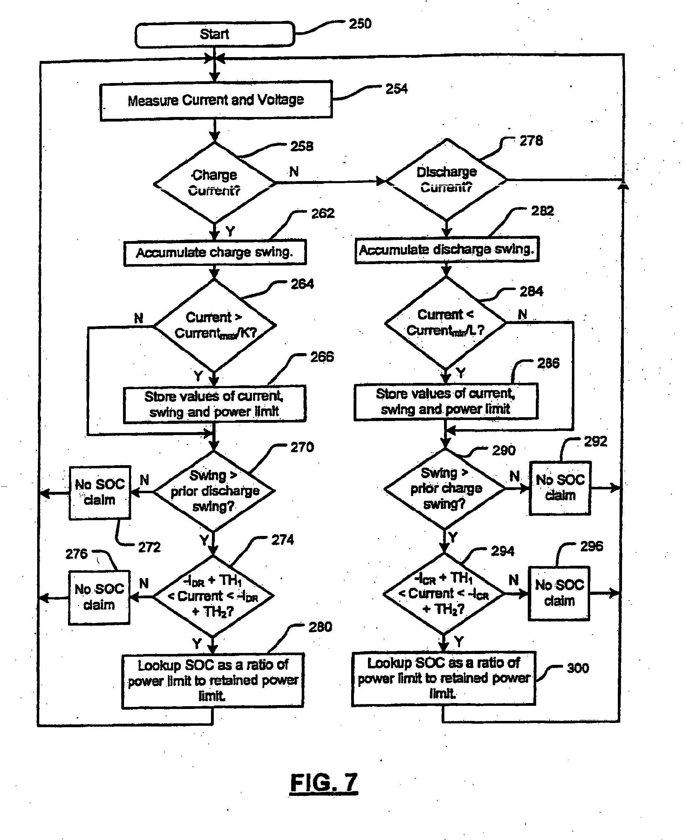

In FIG. 6, the battery current is shown. The present invention monitors charge and discharge swing and declares charge and discharge events under certain circumstances. A charge swing event occurs when the charge swing is greater than a charge swing threshold. A discharge event occurs when a discharge swing is greater than a discharge swing threshold. The thresholds may be related to or based on a prior charge or discharge event. For example, a charge swing threshold may be set equal to the absolute value of a prior discharge event. A discharge swing threshold may be set equal to the absolute value of a prior charge event. Still other approaches may be used to determine the charge and discharge thresholds. As used herein, the term claim refers to situations when a charge or discharge event is followed by a discharge or charge claim and when other conditions described below are met The occurrence of discharge event is determined independently from the occurrence of the discharge claim, to different criteria. The algorithm looks for both simultaneously. For example, the claim point occurs at the time that the area discharge swing is equal to the previous charge swing. The event point occurs when the ratio current vs. discharge current MIN is roughly equal to the ratio current at charge event vs. charge current MAX. This would be the case if L = K in FIG. 7. In some implementations, L and K are between 1 and 2, although other values may be used.

Referring now to FIG. 7, the power ratio SOC estimation method according to the present invention is shown in further detail. Control begins with step 250. In step 254, control measures current and voltage. In step 258, control determines whether there is a charge current Charge current is defined by positive current above zero or a predetermined positive threshold. If step 258 is true, control continues with step 262 and accumulates charge swing. In step 264, control determines whether the current during the charge swing passes a maximum value and is greater than $Current_{max}/K$. When step 264 is true, control stores values of current, charge swing and power limit in step 266. If not, control continues past step 266 to step 270. In step 270, control determines whether the swing is greater than the prior discharge swing. If not, control does not make an SOC claim in step 272 and control continues with step 254.

If step 270 is true, control determines whether the current is approximately equal to a retained discharge current $-I_{DR}$ (in other words within upper and lower thresholds thereof) in step 274. If step 274 is false, control does not make an SOC claim in step 276 and control continues with step 254. If step 274 is true, control looks up SOC as a ratio of power limit to retained power limit in step 280.

If step 258 is false, control continues with step 278 and determines whether discharge current is present. Discharge current is present when discharge current is less than zero or a predetermined negative threshold. If step 278 is false, control returns to step 254. If step 278 is true, control continues with step 282 and accumulates discharge swing. In step 284, control determines whether the current during the discharge swing passes a minimum value and is less than $Current_{min}/L$ When step 284 is true, control stores values of current, the discharge swing and power limit in step 286. If not, control continues past step 286 to step 290. In step 290, control determines whether the discharge swing is greater than the prior charge swing. If not, control does not make an SOC claim in step 292 and control continues with step 254.

If step 290 is true, control determines whether the current is approximately equal to a retained charge current $-I_{CR}$ (in other words within upper and lower thresholds thereof) in step 294. If step 294 is false, control does not make an SOC claim in step 296 and control continues with step 294. If step 294 is true, control looks up SOC as a ratio of power limit to retained power limit in step 300.

Those skilled in the art can now appreciate from the foregoing description that the broad teachings of the present invention can be implemented in a variety of forms. Therefore, while this invention has been described in connection with particular examples thereof, the true scope of the invention which is defined by the claims, should not be so limited since other modifications will become apparent to the skilled practitioner upon a study of the drawings, the specification and the following claims.

**Claims**

1. A battery control module for a battery system, comprising:

a voltage measuring module that measures battery voltage;
a current measuring module that measures battery current; and
a state of charge (SOC) module that communicates with said current and
voltage measuring modules and that estimates SOC **characterised in that** said SOC module estimates SOC when an accumulated charge swing during charge is greater than or equal to a negative of an accumulated discharge swing during a prior discharge and a charge current is within a predetermined window of a negative of a retained discharge current during said prior discharge.

2. The battery control module of Claim 1 wherein said SOC module estimates SOC when an accumulated discharge swing during discharge is greater than or equal to a negative of an accumulated charge swing during a prior charge and a discharge current is within a predetermined window of a negative of a retained charge current during said prior charge.

3. The battery control module of Claim 1 wherein said SOC module calculates a power limit during charging, calculates a power limit ratio based on said power limit during charging and a retained power limit during said prior discharge, and estimates SOC based on a power limit ratio.

4. The battery control module of Claim 2 wherein said SOC module calculates a power limit during discharging, calculates a power limit ratio based on said power limit during discharging and a retained power limit during said prior charge, and estimates SOC based on a power limit ratio.

5. The battery control module of Claim 1 wherein said SOC module accumulates said charge swing during charging until a maximum charge current divided by K is reached and stores said charge current and said charge swing as said accumulated charge swing.

6. The battery control module of Claim 2 wherein said SOC module accumulates said discharge swing during discharging until a minimum discharge current divided by L is reached and stores said minimum discharge current as said discharge current and said discharge swing as said accumulated discharge swing.

7. The battery control module of Claim 3 wherein said SOC module includes a lookup table and wherein said SOC module looks up said SOC as a function of said power limit ratio.

8. The battery control module of Claim 4 wherein said SOC module includes a lookup table and wherein said SOC module looks up said SOC as a function of said power limit ratio.

9. A battery control module for a battery system, comprising:

a voltage measuring module that measures battery voltage;
a current measuring module that measures battery current; and
a state of charge (SOC) module that communicates with said current and
voltage measuring modules and that estimates SOC **characterised in that** said SOC module estimates SOC when an accumulated discharge swing during discharge is greater than or equal to a negative of an accumulated charge swing during a prior charge and a discharge current is within a predetermined window of a negative of a retained charge current during said prior charge.

10. The battery control module of Claim 9 wherein said SOC module estimates SOC when an accumulated charge swing during charge is greater than or equal to a negative of an accumulated discharge swing during a prior discharge and a charge current is within a predetermined window of a negative of a retained discharge current during said prior discharge.

11. The battery control module of Claim 10 wherein said SOC module calculates a power limit during charging, calculates a power limit ratio based on said power limit during charging and a retained power limit during said prior discharge, and estimates SOC based on a power limit ratio.

12. The battery control module of Claim 9 wherein said SOC module calculates a power limit during discharging, calculates a power limit ratio based on said power limit during discharging and a retained power limit during said prior charge, and estimates SOC based on a power limit ratio.

13. The battery control module of Claim 10 wherein said SOC module accumulates said charge swing during charging until a maximum charge current divided by K is reached and stores said maximum charge current as said charge current and said charge swing as said accumulated charge swing.

14. The battery control module of Claim 9 wherein said SOC module accumulates said discharge swing during discharging until a minimum discharge current divided by L is reached and stores said minimum discharge current as said discharge current and said discharge swing as said accumulated discharge swing.

15. The battery control module of Claim 11 wherein said SOC module includes a lookup table and wherein said SOC module looks up said SOC as a function of said power limit ratio.

16. The battery control module of Claim 12 wherein said SOC module includes a lookup table and wherein said SOC module looks up said SOC as a function of said power limit ratio.

17. A method for operating a battery control module for a battery system, comprising:

measuring battery voltage;
measuring battery current; and
estimating state of charge (SOC) **characterised in that** SOC is estimated when an accumulated charge swing during charge is greater than or equal to a negative of an accumulated discharge swing during a prior discharge and a charge current is within a predetermined window of a negative of a retained discharge current during said prior discharge.

18. The method of Claim 17 further comprising estimating said SOC when an accumulated discharge swing during discharge is greater than or equal to a negative of an accumulated charge swing during a prior charge and a discharge current is within a predetermined window of a negative of a retained charge current during said prior charge.

19. The method of Claim 17 further comprising:

calculating a power limit during charging;
calculating a power limit ratio based on said power limit during charging and
a retained power limit during said prior discharge; and
estimating SOC based on a power limit ratio.

20. The method of Claim 18 further comprising:

calculating a power limit during discharging;
calculating a power limit ratio based on said power limit during discharging and a retained power limit during said prior charge; and
estimating SOC based on a power limit ratio.

21. The method of Claim 17 further comprising:

accumulating said charge swing during charging until a maximum charge current divided by K is reached; and
storing said charge current and said charge swing as said accumulated charge swing.

**22.** The method of Claim 18 further comprising:

accumulating said discharge swing during discharging until a minimum discharge current divided by L is reached; and
storing said discharge current and said discharge swing as said accumulated discharge swing.

**23.** The method of Claim 19 wherein said SOC module includes a lookup table and wherein said SOC module looks up said SOC as a function of said power limit ratio.

**24.** The method of Claim 20 wherein said SOC module includes a lookup table and wherein said SOC module looks up said SOC as a function of said power limit ratio.

**25.** A method for operating a battery control module for a battery system, comprising:

measuring battery voltage;
measuring battery current; and
estimating state of charge (SOC) **characterised in that** SOC is estimated when an accumulated discharge swing during discharge is greater than or
equal to a negative of an accumulated charge swing during a prior charge and a discharge current is within a predetermined window of a negative of a retained charge current during said prior charge.

**26.** The method of Claim 25 further comprising estimating said SOC when an accumulated charge swing during charge is greater than or equal to a negative of an accumulated discharge swing during a prior discharge and a charge current is within a predetermined window of a negative of a retained discharge current during said prior discharge.

**27.** The method of Claim 26 further comprising:

calculating a power limit during charging;
calculating a power limit ratio based on said power limit during charging and
a retained power limit during said prior discharge; and
estimating SOC based on a power limit ratio.

**28.** The method of Claim 25 further comprising:

calculating a power limit during discharging;
calculating a power limit ratio based on said power limit during discharging and a retained power limit during said prior charge; and
estimating SOC based on a power limit ratio.

**29.** The method of Claim 26 further comprising:

accumulating said charge swing during charging until a maximum charge current divided by K is reached; and
storing said charge current and said charge swing as said accumulated charge swing.

**30.** The method of Claim 25 further comprising:

accumulating said discharge swing during discharging until a minimum discharge current divided by L is reached; and
storing said discharge current and said discharge swing as said accumulated discharge swing.

**31.** The method of Claim 26 wherein said SOC module includes a lookup table and wherein said SOC module looks up said SOC as a function of said power limit ratio.

**32.** The method of Claim 27 wherein said SOC module includes a lookup table and wherein said SOC module looks up said SOC as a function of said power limit ratio.

**Patentansprüche**

**1.** Batteriesteuerungsmodul für ein Batteriesystem, umfassend:

ein Spannungsmessungsmodul, das eine Batteriespannung misst;
ein Strommessungsmodul, das einen Batteriestrom misst; und
ein Ladezustands(SOC)-Modul, das mit den Strom- und Spannungsmessungsmodulen kommuniziert und das einen SOC schätzt, **dadurch gekennzeichnet, dass**
das SOC-Modul einen SOC schätzt, wenn eine beim Aufladen akkumulierte Aufladungsschwankung größer oder gleich dem Negativen einer bei einem vorherigen Entladen akkumulierten Entladungsschwankung ist und ein Aufladestrom innerhalb eines vorbestimmten Fensters des Negativen eines beim vorherigen Entladen beibehaltenen Entladestroms liegt.

**2.** Batteriesteuerungsmodul nach Anspruch 1, wobei das SOC-Modul einen SOC schätzt, wenn eine bei einem Entladen akkumulierte Entladungsschwankung größer oder gleich dem Negativen einer bei einem vorherigen Aufladen akkumulierten Aufladungsschwankung ist und ein Entladestrom innerhalb eines vorbestimmten Fensters des Negativen eines beim vorherigen Aufladen beibehaltenen Aufladestroms liegt.

**3.** Batteriesteuerungsmodul nach Anspruch 1, wobei das SOC-Modul eine Leistungsgrenze beim Aufladen berechnet, ein Leistungsgrenzenverhältnis beruhend auf der Leistungsgrenze beim Aufladen und einer Grenze für beibehaltene Leistung beim vorherigen Entladen berechnet, und einen SOC beruhend auf einem Leistungsgrenzenverhältnis schätzt.

**4.** Batteriesteuerungsmodul nach Anspruch 2, wobei das SOC-Modul eine Leistungsgrenze beim Entladen berechnet, ein Leistungsgrenzenverhältnis beruhend auf der Leistungsgrenze beim Entladen und einer Grenze für beibehaltene Leistung beim vorherigen Aufladen berechnet, und einen SOC beruhend auf einem Leistungsgrenzenverhältnis schätzt.

**5.** Batteriesteuerungsmodul nach Anspruch 1, wobei das SOC-Modul die Aufladungsschwankung beim Aufladen akkumuliert, bis ein maximaler Aufladestrom dividiert durch K erreicht wird, und den Aufladestrom und die Aufladungsschwankung als die akkumulierte Aufladungsschwankung speichert.

**6.** Batteriesteuerungsmodul nach Anspruch 2, wobei das SOC-Modul die Entladungsschwankung beim Entladen akkumuliert, bis ein minimaler Entladestrom dividiert durch L erreicht wird, und den minimalen Entladestrom als den Entladestrom und die Entladungsschwankung als die akkumulierte Entladungsschwankung speichert.

**7.** Batteriesteuerungsmodul nach Anspruch 3, wobei das SOC-Modul eine Nachschlagetabelle umfasst und wobei das SOC-Modul den SOC als Funktion des Leistungsgrenzenverhältnisses nachschlägt.

**8.** Batteriesteuerungsmodul nach Anspruch 4, wobei das SOC-Modul eine Nachschlagetabelle umfasst, und wobei das SOC-Modul den SOC als Funktion des Leistungsgrenzenverhältnisses nachschlägt.

**9.** Batteriesteuerungsmodul für ein Batteriesystem, umfassend:

ein Spannungsmessungsmodul, das eine Batteriespannung misst;
ein Strommessungsmodul, das einen Batteriestrom misst; und
ein Ladezustands(SOC)-Modul, das mit den Strom- und Spannungsmessungsmodulen kommuniziert und das einen SOC schätzt, **dadurch gekennzeichnet, dass**

das SOC-Modul einen SOC schätzt, wenn eine beim Entladen akkumulierte Entladungsschwankung größer oder gleich dem Negativen einer bei einem vorherigen Aufladen akkumulierten Aufladungsschwankung ist und ein Entladestrom innerhalb eines vorbestimmten Fensters des Negativen eines beim vorherigen Aufladen beibehaltenen Aufladestroms liegt.

**10.** Batteriesteuerungsmodul nach Anspruch 9, wobei das SOC-Modul einen SOC schätzt, wenn eine beim Aufladen akkumulierte Aufladungsschwankung größer oder gleich dem Negativen einer bei einem vorherigen Entladen akkumulierten Entladungsschwankung ist und ein Aufladestrom innerhalb eines vorbestimmten Fensters des Negativen eines beim vorherigen Entladen beibehaltenen Entladestroms liegt.

**11.** Batteriesteuerungsmodul nach Anspruch 10, wobei das SOC-Modul eine Leistungsgrenze beim Aufladen berechnet, ein Leistungsgrenzenverhältnis beruhend auf der Leistungsgrenze beim Aufladen und einer Grenze für beibehaltene Leistung beim vorherigen Entladen berechnet, und einen SOC beruhend auf einem Leistungsgrenzenverhältnis schätzt.

**12.** Batteriesteuerungsmodul nach Anspruch 9, wobei das SOC-Modul eine Leistungsgrenze beim Entladen berechnet, ein Leistungsgrenzenverhältnis beruhend auf der Leistungsgrenze beim Entladen und einer Grenze für beibehaltene Leistung beim vorherigen Aufladen berechnet, und einen SOC beruhend auf einem Leistungsgrenzenverhältnis schätzt.

**13.** Batteriesteuerungsmodul nach Anspruch 10, wobei das SOC-Modul die Aufladungsschwankung beim Aufladen akkumuliert, bis ein maximaler Aufladestrom dividiert durch K erreicht wird, und den maximalen Aufladestrom als den Aufladestrom und die Aufladungsschwankung als die akkumulierte Aufladungsschwankung speichert.

**14.** Batteriesteuerungsmodul nach Anspruch 9, wobei das SOC-Modul die Entladungsschwankung beim Entladen akkumuliert, bis ein minimaler Entladestrom dividiert durch L erreicht wird, und den minimalen Entladestrom als den Entladestrom und die Entladungsschwankung als die akkumulierte Entladungsschwankung speichert.

**15.** Batteriesteuerungsmodul nach Anspruch 11, wobei das SOC-Modul eine Nachschlagetabelle umfasst, und wobei das SOC-Modul den SOC als Funktion des Leistungsgrenzenverhältnisses nachschlägt.

**16.** Batteriesteuerungsmodul nach Anspruch 12, wobei das SOC-Modul eine Nachschlagetabelle umfasst, und wobei das SOC-Modul den SOC als Funktion des Leistungsgrenzenverhältnisses nachschlägt.

**17.** Verfahren zum Betreiben eines Batteriesteuerungsmoduls für ein Batteriesystem, wobei das Verfahren umfasst, dass:

eine Batteriespannung gemessen wird;
ein Batteriestrom gemessen wird; und
ein Ladezustand (SOC) geschätzt wird,
**dadurch gekennzeichnet, dass**
ein SOC geschätzt wird, wenn eine beim Aufladen akkumulierte Aufladungsschwankung größer oder gleich dem Negativen einer bei einem vorherigen Entladen akkumulierten Entladungsschwankung ist und ein Aufladestrom innerhalb eines vorbestimmten Fensters des Negativen eines beim vorherigen Entladen beibehaltenen Entladestroms liegt.

**18.** Verfahren nach Anspruch 17, das ferner umfasst, dass der SOC geschätzt wird, wenn eine beim Entladen akkumulierte Entladungsschwankung größer oder gleich dem Negativen einer bei einem vorherigen Aufladen akkumulierten Aufladungsschwankung ist und ein Entladestrom innerhalb eines vorbestimmten Fensters des Negativen eines beim vorherigen Aufladen beibehaltenen Aufladestroms liegt.

**19.** Verfahren nach Anspruch 17, das ferner umfasst, dass:

eine Leistungsgrenze beim Aufladen berechnet wird;
ein Leistungsgrenzenverhältnis beruhend auf der Leistungsgrenze beim Aufladen und einer Grenze für beim vorherigen Entladen beibehaltene Leistung berechnet wird; und
ein SOC beruhend auf einem Leistungsgrenzenverhältnis geschätzt wird.

**20.** Verfahren nach Anspruch 18, das ferner umfasst, dass:

eine Leistungsgrenze beim Entladen berechnet wird;
ein Leistungsgrenzenverhältnis beruhend auf der Leistungsgrenze beim Entladen und einer Grenze für beim vorherigen Aufladen beibehaltene Leistung berechnet wird; und
ein SOC beruhend auf einem Leistungsgrenzenverhältnis geschätzt wird.

**21.** Verfahren nach Anspruch 17, das ferner umfasst, dass:

die Aufladungsschwankung beim Aufladen akkumuliert wird, bis ein maximaler Aufladestrom dividiert durch K erreicht wird; und
der Aufladestrom und die Aufladungsschwankung als die akkumulierte Aufladungsschwankung gespeichert werden.

**22.** Verfahren nach Anspruch 18, das ferner umfasst, dass:

die Entladungsschwankung beim Entladen akkumuliert wird, bis ein minimaler Entladestrom dividiert durch L erreicht wird; und
der Entladestrom und die Entladungsschwankung als die akkumulierte Entladungsschwankung gespeichert werden.

**23.** Verfahren nach Anspruch 19, wobei das SOC-Modul eine Nachschlagetabelle umfasst, und wobei das SOC-Modul den SOC als Funktion des Leistungsgrenzenverhältnisses nachschlägt.

**24.** Verfahren nach Anspruch 20, wobei das SOC-Modul eine Nachschlagetabelle umfasst, und wobei das SOC-Modul den SOC als Funktion des Leistungsgrenzenverhältnisses nachschlägt.

**25.** Verfahren zum Betreiben eines Batteriesteuerungsmoduls für ein Batteriesystem, wobei das Verfahren umfasst, dass:

eine Batteriespannung gemessen wird;
ein Batteriestrom gemessen wird; und
ein Ladezustand (SOC) geschätzt wird,
**dadurch gekennzeichnet, dass**
ein SOC geschätzt wird, wenn eine beim Entladen akkumulierte Entladungsschwankung größer oder gleich dem Negativen einer bei einem vorherigen Aufladen akkumulierten Aufladungsschwankung ist und ein Entladestrom innerhalb eines vorbestimmten Fensters des Negativen eines beim vorherigen Aufladen beibehaltenen Aufladestroms liegt.

**26.** Verfahren nach Anspruch 25, das ferner umfasst, dass der SOC geschätzt wird, wenn eine beim Aufladen akkumulierte Aufladungsschwankung größer oder gleich dem Negativen einer bei einem vorherigen Entladen akkumulierten Entladungsschwankung ist und ein Aufladestrom innerhalb eines vorbestimmten Fensters des Negativen eines beim vorherigen Entladen beibehaltenen Entladestroms liegt.

**27.** Verfahren nach Anspruch 26, das ferner umfasst, dass:

eine Leistungsgrenze beim Aufladen berechnet wird;
ein Leistungsgrenzenverhältnis beruhend auf der Leistungsgrenze beim Aufladen und einer Grenze für beim vorherigen Entladen beibehaltene Leistung berechnet wird; und
ein SOC beruhend auf einem Leistungsgrenzenverhältnis geschätzt wird.

**28.** Verfahren nach Anspruch 25, das ferner umfasst, dass:

eine Leistungsgrenze beim Entladen berechnet wird;
ein Leistungsgrenzenverhältnis beruhend auf der Leistungsgrenze beim Entladen und einer Grenze für beim vorherigen Aufladen beibehaltene Leistung berechnet wird; und
ein SOC beruhend auf einem Leistungsgrenzenverhältnis geschätzt wird.

**29.** Verfahren nach Anspruch 26, das ferner umfasst, dass:

die Aufladungsschwankung beim Aufladen akkumuliert wird, bis ein maximaler Aufladestrom dividiert durch K erreicht wird; und
der Aufladestrom und die Aufladungsschwankung als die akkumulierte Aufladungsschwankung gespeichert werden.

**30.** Verfahren nach Anspruch 25, das ferner umfasst, dass:

die Entladungsschwankung beim Entladen akkumuliert wird, bis ein minimaler Entladestrom dividiert durch L erreicht wird; und
der Entladestrom und die Entladungsschwankung als die akkumulierte Entladungsschwankung gespeichert werden.

**31.** Verfahren nach Anspruch 26,
wobei das SOC-Modul eine Nachschlagetabelle umfasst, und wobei das SOC-Modul den SOC als Funktion des Leistungsgrenzenverhältnisses nachschlägt.

**32.** Verfahren nach Anspruch 27,
wobei das SOC-Modul eine Nachschlagetabelle umfasst, und wobei das SOC-Modul den SOC als Funktion des Leistungsgrenzenverhältnisses nachschlägt.

**Revendications**

**1.** Module de commande de batterie pour un système de batterie, comprenant :

un module de mesure de voltage qui mesure un voltage de batterie ;
un module de mesure de courant qui mesure un courant de batterie ; et
un module d'état de charge (EDC) qui communique avec ledit module de mesure de courant et ledit module de mesure de voltage et qui estime l'état de charge, **caractérisé en ce que** le module d'état de charge estime l'état de charge quand une variation de charge accumulée pendant une charge est supérieure ou égale à une valeur négative d'une variation de décharge accumulée pendant une décharge antérieure et quand un courant de charge tombe dans une fenêtre prédéterminée d'une valeur négative d'un courant de charge retenu pendant ladite décharge antérieure.

**2.** Module de commande de batterie selon la revendication 1, dans lequel ledit module EDC estime le EDC quand une variation de décharge accumulée pendant une décharge est supérieure ou égale à une valeur négative d'une variation de charge accumulée pendant une charge antérieure, et quand un courant de décharge tombe dans une fenêtre prédéterminée d'une valeur négative d'un courant de charge retenu pendant ladite charge antérieure.

**3.** Module de commande de batterie selon la revendication 1, dans lequel ledit module EDC calcule une limite de puissance pendant la charge, calcule un rapport limite de puissance sur la base de ladite limite de puissance pendant la charge et une limite de puissance retenue pendant ladite décharge antérieure, et estime le EDC sur la base d'un rapport limite de puissance.

**4.** Module de commande de batterie selon la revendication 2, dans lequel ledit module EDC calcule une limite de puissance pendant la décharge, calcule un rapport limite de puissance basé sur ladite limite de puissance pendant la décharge et une limite de puissance retenue pendant ladite charge antérieure, et estime le EDC sur la base d'un rapport de limite de puissance.

**5.** Module de commande de batterie selon la revendication 1, dans lequel ledit module EDC accumule ladite variation de charge pendant la charge jusqu'à atteindre un courant de charge maximum divisé par K, et stocke ledit courant de charge et ladite variation de charge comme étant ladite variation de charge accumulée.

**6.** Module de commande de batterie selon la revendication 2, dans lequel ledit module EDC accumule ladite variation de décharge pendant la décharge jusqu'à atteindre un courant de décharge minimum divisé par L, et stocke ledit courant de décharge minimum comme étant ledit courant de décharge et ladite variation de décharge comme étant ladite variation de décharge accumulée.

**7.** Module de commande de batterie selon la revendication 3, dans lequel ledit module EDC inclut une table de lecture, et dans lequel ledit module EDC effectue une lecture dudit EDC comme étant une fonction dudit rapport limite de puissance.

**8.** Module de commande de batterie selon la revendication 4, dans lequel ledit module EDC inclut une table de lecture, et dans lequel ledit module EDC effectue une lecture dudit EDC comme étant une fonction dudit rapport limite de puissance.

**9.** Module de commande de batterie pour un système de batterie, comprenant :

un module de mesure de voltage qui mesure un voltage de batterie ;
un module de mesure de courant qui mesure un courant de batterie ; et
un module d'état de charge (EDC) qui communique avec ledit module de mesure de courant et ledit module de mesure de voltage et qui estime un EDC, **caractérisé en ce que** ledit module EDC estime le EDC quand une variation de décharge accumulée pendant la décharge est supérieure ou égale à une valeur négative d'une variation de charge accumulée pendant une charge antérieure et quand un courant de décharge tombe dans une fenêtre prédéterminée d'une valeur négative d'un courant de charge retenu pendant ladite charge antérieure.

**10.** Module de commande de batterie selon la revendication 9, dans lequel ledit module EDC estime le EDC quand une variation de charge accumulée pendant la charge est supérieure ou égale à une valeur négative d'une variation de décharge accumulée pendant une décharge antérieure et quand un courant de charge tombe dans une fenêtre prédéterminée d'une valeur négative d'une décharge retenue pendant ladite décharge antérieure.

**11.** Module de commande de batterie selon la revendication 10, dans lequel ledit module EDC calcule une limite de puissance pendant la charge, calcule un rapport de limite de puissance basé sur ladite limite de puissance pendant la charge et une limite de puissance retenue pendant ladite décharge antérieure, et estime le EDC sur la base d'un rapport limite de puissance.

**12.** Module de commande de batterie selon la revendication 9, dans lequel ledit module EDC calcule une limite de puissance pendant la décharge, calcule un rapport de limite de puissance basé sur ladite limite de puissance pendant la décharge, et une limite de puissance retenue pendant ladite charge antérieure, et estime le EDC sur la base d'un rapport limite de puissance.

**13.** Module de commande de batterie selon la revendication 10, dans lequel ledit module EDC accumule ladite variation de charge pendant la charge jusqu'à atteindre un courant de charge maximum divisé par K et stocke ledit courant de charge maximum comme étant ledit courant de charge et ladite variation de charge comme étant ladite variation de charge accumulée.

**14.** Module de commande de batterie selon la revendication 9, dans lequel ledit module EDC accumule ladite variation de décharge pendant la décharge jusqu'à atteindre un courant de décharge minimum divisé par L et stocke ledit courant de décharge minimum comme étant ledit courant de décharge et ladite variation de décharge comme étant ladite variation de décharge accumulée.

**15.** Module de commande de batterie selon la revendication 11, dans lequel ledit module EDC inclut une table de lecture, et dans lequel ledit module EDC effectue une lecture dudit EDC en tant que fonction dudit rapport limite de puissance.

**16.** Module de commande de batterie selon la revendication 12, dans lequel ledit module EDC inclut une table de lecture, et dans lequel ledit module EDC effectue une lecture dudit EDC en tant que fonction dudit rapport limite de puissance.

**17.** Procédé pour le fonctionnement d'un module de commande de batterie pour un système de batterie, comprenant les étapes consistant à:

mesurer un voltage de batterie ;
mesurer un courant de batterie ; et
estimer un état de charge (EDC),
**caractérisé en ce que** le EDC est estimé quand une variation de charge accumulée pendant la charge est supérieure ou égale à une valeur négative d'une variation de décharge accumulée pendant une décharge antérieure et quand un courant de charge tombe dans une fenêtre prédéterminée d'une valeur négative d'un courant de décharge retenu pendant ladite décharge antérieure.

**18.** Procédé selon la revendication 17, comprenant en outre l'étape consistant à estimer ledit EDC quand une variation de décharge accumulée pendant la décharge est supérieure ou égale à une valeur négative d'une variation de charge accumulée pendant une charge antérieure et quand un courant de décharge tombe dans une fenêtre prédéterminée d'une valeur négative d'un courant de charge retenu pendant ladite charge antérieure.

**19.** Procédé selon la revendication 17, comprenant en outre les étapes consistant à :

calculer une limite de puissance pendant la charge ;
calculer un rapport de limite de puissance basé sur ladite limite de puissance pendant la charge et une limite de puissance retenue pendant ladite décharge antérieure ; et
estimer le EDC sur la base d'un rapport de limite de puissance.

**20.** Procédé selon la revendication 18, comprenant en outre les étapes consistant à :

calculer une limite de puissance pendant la décharge ;
calculer un rapport limite de puissance basé sur ladite limite de puissance pendant la décharge et une limite de puissance retenue pendant ladite charge antérieure ; et
estimer le EDC sur la base d'un rapport limite de puissance.

**21.** Procédé selon la revendication 17, comprenant en outre les étapes consistant à :

accumuler ladite variation de charge pendant la charge jusqu'à atteindre un courant de charge maximum divisé par K ; et
stocker ledit courant de charge et ladite variation de charge comme étant ladite variation de charge accumulée.

**22.** Procédé selon la revendication 18, comprenant en outre les étapes consistant à :

accumuler ladite variation de décharge pendant la décharge jusqu'à atteindre un courant de décharge minimum divisé par L ; et
stocker ledit courant de décharge et ladite variation de décharge comme étant ladite variation de décharge accumulée.

**23.** Procédé selon la revendication 19, dans lequel ledit module EDC inclut une table de lecture, et dans lequel ledit module EDC effectue une lecture dudit EDC comme étant une fonction dudit rapport limite de puissance.

**24.** Procédé selon la revendication 20, dans lequel ledit module EDC inclut une table de lecture, et dans lequel ledit module EDC effectue une lecture dudit EDC en tant que fonction dudit rapport limite de puissance.

**25.** Procédé pour le fonctionnement d'un module de commande de batterie pour un système de batterie, comprenant les étapes consistant à :

mesurer un voltage de batterie ;
mesurer un courant de batterie ; et
estimer un état de charge (EDC),
**caractérisé en ce que** le EDC est estimé quand une variation de décharge accumulée pendant la décharge est supérieure ou égale à une valeur négative d'une variation de charge accumulée pendant une charge antérieure et quand un courant de décharge tombe dans une fenêtre prédéterminée d'une valeur négative du courant de charge retenu pendant ladite charge antérieure.

**26.** Procédé selon la revendication 25, comprenant en outre l'étape consistant à estimer ledit EDC quand une variation de charge accumulée pendant la charge est supérieure ou égale à une valeur négative d'une variation de décharge accumulée pendant une décharge antérieure et quand un courant de charge tombe dans une fenêtre prédéterminée d'une valeur négative d'un courant de décharge retenu pendant ladite décharge antérieure.

**27.** Procédé selon la revendication 26, comprenant en outre les étapes consistant à :

calculer une limite puissance pendant la charge ;
calculer un rapport limite de puissance basé sur ladite limite de puissance pendant la charge et une limite de puissance retenue pendant ladite décharge antérieure ; et
estimer le EDC sur la base d'un rapport limite de puissance.

**28.** Procédé selon la revendication 25, comprenant en outre les étapes consistant à :

calculer une limite de puissance pendant la décharge ;
calculer une un rapport limite de puissance basé sur ladite limite de puissance pendant la décharge et une limite de puissance retenue pendant ladite charge antérieure ; et
estimer le EDC sur la base d'un rapport limite de puissance.

**29.** Procédé selon la revendication 26, comprenant en outre les étapes consistant à :

accumuler ladite variation de charge pendant la charge jusqu'à atteindre un courant de charge maximum divisé par K ; et
stocker ledit courant de charge et ladite variation de charge comme étant ladite variation de charge accumulée.

**30.** Procédé selon la revendication 25, comprenant en outre les étapes consistant à :

accumuler ladite variation de décharge pendant la décharge jusqu'à atteindre un courant de décharge minimum divisé par L ; et
stocker ledit courant de décharge et ladite variation de décharge comme étant ladite variation de décharge accumulée.

**31.** Procédé selon la revendication 26, dans lequel ledit module EDC inclut une table de lecture, et dans lequel ledit module EDC effectue une lecture dudit EDC en tant que fonction dudit rapport limite de puissance.

**32.** Procédé selon la revendication 27, dans lequel ledit module EDC inclut une table de lecture, et dans lequel ledit module EDC effectue une lecture dudit EDC en tant que fonction dudit rapport limite de puissance.

FIG. 1

EP 1 754 977 B1

Battery Control Module

LUTs — 70

SOC Module — 66

LUTs ↕ SOC Module

Power Limit Module — 72

Clock — 76

Voltage and/or Current Measuring Module — 60

— 30

Contactor Control Module — 74

**FIG. 2**

$$V_\phi$$

$$R_0$$

$$R_P$$

$$C$$

$$V$$

**FIG. 3**

Current

100-1    100-3    100-4
106    108    100-2
112
0    Time
110
102-1    102-2    102-3

**FIG. 4**

Current

Charge Swing
Charge Event
0    Time

Discharge Event
And Claim
Discharge Swing

**FIG. 6**

**FIG. 5A**

```
                    ( 1 )
                      │
                      ▼
        ┌──────────────────────────┐      ┌─ 200
        │     Increment rest       │
        └──────────────────────────┘
                      │
                      ▼
                   ╱─────────╲   ┌─ 202
                  ╱  Rest time ╲     N
                 ╱  adequate?   ╲ ──────────────────────────────────┐
                  ╲            ╱                                      │
                   ╲─────────╱                                       │
                      │ Y                                            │
                      ▼                                              │
                   ╱─────────╲   ┌─ 204                              │
                  ╱ Allowable ╲     N                                │
                 ╱ time <Th_time?╲ ─────────────────────────────────┤
                  ╲            ╱                                      │
                   ╲─────────╱                                       │
                      │ Y                                            │
                      ▼                                              │
                   ╱─────────╲   ┌─ 206          ╱─────────╲  ┌─ 212 │
                  ╱ SOC lookup ╲     N          ╱ SOC lookup ╲   N    │
                 ╱ after charge ╲ ─────────────╱ after discharge╲ ───┤
                  ╲  enabled?  ╱               ╲  enabled?  ╱         │
                   ╲─────────╱                  ╲─────────╱          │
                      │ Y                           │ Y              │
                      ▼        ┌─ 208               ▼      ┌─ 214     │
        ┌──────────────────────┐         ┌──────────────────────┐    │
        │ Lookup SOC as function of│     │ Lookup SOC as function of│ │
        │   relaxation voltage     │     │   relaxation voltage     │ │
        └──────────────────────┘         └──────────────────────┘    │
                      │        ┌─ 210               │      ┌─ 216     │
                      ▼                              ▼                 │
        ┌──────────────────────┐         ┌──────────────────────┐    │
        │  Disable SOC lookup after│     │  Disable SOC lookup after│ │
        │        charge            │     │       discharge          │ │
        └──────────────────────┘         └──────────────────────┘    │
                      │                              │                │
                      ├──────────────────────────────┘                │
                      ▼                                                │
                    ( 2 ) ◄──────────────────────────────────────────┘
```

## FIG. 5B

**FIG. 7**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 55992104 P
- US 08197905 A
- US 08198005 A
- US 11081978 B
- EP 1085592 A